# EUROPÄISCHE PATENTSCHRIFT

(11) **EP 0 992 808 B1**
(45) Veröffentlichungstag und Bekanntmachung des Hinweises auf die Patenterteilung: **23.11.2005**
(21) Anmeldenummer: 99117216.4
(22) Anmeldetag: 01.09.1999
(51) Int. Cl.: G01R 31/317, G11C 29/00

(54) **Integrierter Schaltkreis mit zwei Betriebszuständen**
Integrated circuit with two modes of operation
Circuit integré avec deux modes de functionnement

(30) Priorität: 15.09.1998 DE 19842208
(43) Veröffentlichungstag der Anmeldung: 12.04.2000
(73) Patentinhaber: Infineon Technologies AG, 81669 München (DE)
(72) Erfinder: Bauer, Regine, 81735 München (DE); Krause, Gunnar, 81541 München (DE)
(74) Vertreter: Epping - Hermann - Fischer

(56) Entgegenhaltungen:
- US-A- 4 902 917
- US-A- 5 212 442
- US-A- 5 592 422

## Beschreibung

Die Erfindung betrifft einen integrierten Schaltkreis, der eine Funktionseinrichtung umfaßt, die einen ersten und einen zweiten Betriebszustand einnehmen kann, sowie eine Steuerungseinrichtung zur Umschaltung zwischen den Zuständen.

Taktsynchron arbeitende Halbleiterspeicher, sogenannte SDRAMs, weisen eine Standby-Betriebsart und eine Vollbetriebsart (Active-Mode) auf, wie im Siemens-Datenblatt "HYB39S64400/800/160AT(L), 64MBit Synchronous DRAM", Ausgabe 7.98, Seiten 7 bis 13, insbesondere Seite 8, beschrieben ist. Wenn die Versorgungsspannung angelegt wird, befindet sich der Chip im Standby-Mode. Durch Eingabe einer Folge von Steuersignalen wird das Betriebsartenregister (Mode-Register) gesetzt und der Active-Mode eingestellt. Es sind die Befehle "Mode Register Set", "Precharge All", "Auto/Self Refresh", "Row Activate" nacheinander einzugeben. Einschließlich der Versorgungsspannung sind hierzu acht Anschlußstifte mit Spannung bzw. Signalen zu versorgen: VDD, VSS, CKE, CS, CLK, RAS, CAS, WE.

Beim Betrieb im Anwendungssystem werden die Signale von einem Mikrocontroller über die Anschlüsse des Gehäuses dem Chip zugeführt. Um beim Test des Halbleiterchips Funktionsmerkmale im Active-Mode zu testen, muß die Testeinrichtung in der Lage sein, die obengenannten Signale in der erforderlichen Reihenfolge anzulegen. Insbesondere Testausrüstung, mit der ein Sichttest einer Halbleiterscheibe am Ende der Herstellung und vor dem Zersägen in die einzelnen Chips durchgeführt wird, weist oftmals entsprechende Einrichtungen für die Zuführung solcher Signale nicht auf. Außerdem sind acht Nadeln auf dem Chip aufzusetzen, um die Signale zuzuführen. Da bei integrierten Halbleiterspeichern die Anschlußflächen für Eingabesignale nicht etwa am Rand des Chips, sondern in dessen Mitte liegen, wird Chipfläche verdeckt und die Sichtkontrolle eingeschränkt. Bei manueller Positionierung der Probe-Nadeln ist erheblicher Arbeitsaufwand erforderlich.

In der US 5 212 442 ist ein integrierter Schaltkreis beschrieben, mit dem ein Testmodus eingestellt werden kann, durch den die Substratvorspannung für das den integrierten Schaltkreis enthaltende Halbleitersubstrat auf Masse gezogen werden kann. Über einen externen Anschlusspin wird ein Testmodusdetektor versorgt, der das Testmodussignal ausgibt. Ein davon angesteuerter Inverter weist einen zusätzlichen masseseitigen Transistor auf, auf den der Ausgang des Inverters rückgekoppelt ist. Dieser masseseitiger Transistor sorgt dafür, das Substrat mit Masse zu verbinden.

In der US 5 592 422 ist eine Schaltung beschrieben, die zwei extern zugeführte Testmodussignale auswertet. Diese werden zwei Gattern zugeführt, welche die Versorgungsanschlüsse eines Inverters mit Versorgungsspannung verbinden oder davon abschalten. Der Inverter ist mit einem Adresspad verbunden, um den Adresspuffer dadurch abzuschalten. In Abhängigkeit von den Testmodussignalen wird der Rest der Schaltung in verschiedenen Betriebsarten betrieben, beispielsweise Normalbetrieb und verschiedene Testbetriebsarten, bei denen ein Speicherzellenfeld unterschiedlich vorbesetzt wird.

Die Aufgabe der Erfindung besteht darin, einen integrierten Schaltkreis mit einer in einem ersten und einem zweiten Betriebszustand betreibbaren Funktionseinrichtung anzugeben, bei der eine Betriebsart mittels einer Kombination extern anzulegender Steuersignale einerseits und mittels eines einzigen Signals andererseits einstellbar ist.

Erfindungsgemäß wird diese Aufgabe durch einen integrierten Schaltkreis nach den Merkmalen des Patentanspruchs 1 gelöst. Gemäß der Erfindung wird über ein Anschlußpad ein einziges Signal eingekoppelt, aus dem dann die Kombination von Steuersignalen erzeugbar ist, durch die ansonsten im Normalbetrieb die Umschaltung vom einen in den anderen Betriebszustand veranlaßt wird. Beim Test der integrierten Schaltung ist die Zuführung nur noch eines einzigen Steuersignals und zusätzlich der Versorgungsspannung erforderlich. Zweckmäßigerweise wird das Anschlußpad wesentlich kleiner ausgeführt als ein übliches anderes Anschlußpad, welches für eine Bondverbindung an einen Gehäusepin vorgesehen ist.

Die Schaltungsmittel zum Erzeugen der Steuersignalkombination für die Umschaltung zwischen den Betriebszuständen sind so beschaltet, daß sie im Normalbetrieb, wenn kein Steuersignal am Testpad anliegt, sicher deaktiviert sind. Hierzu eignet sich zweckmäßigerweise ein Pull up- oder Pull down-Widerstand, abhängig davon, welche Polarität ein aktives an das Testpad anzulegendes Steuersignal aufweist. Zweckmäßigerweise ist das Steuersignal am Testpad Low-aktiv, so daß ein Pull up-Widerstand vorgesehen ist. Zweckmäßigerweise liegt außerdem ein Schalttransistor parallel zum Pull up-Widerstand, der vom am Testpad anzulegenden Signal gegenphasig gesteuert wird. Über logische Verknüpfungselemente wird das über das Testpad eingekoppelte Signal mit der Steuersignalkombination, die der Umschaltung zwischen den Betriebszuständen dient, verknüpft. Die Verknüpfung wirkt derart, daß bei aktivem Steuersignal am Testpad diejenige Kombination von Signalzuständen erzeugt wird, durch die von Standby- in den Aktive-Mode umgeschaltet wird. Andernfalls sind die Verknüpfungselemente für die vom Systemcontroller erzeugten Steuersignale transparent.

Nachfolgend wird die Erfindung anhand der in der Zeichnung dargestellten Figuren näher erläutert.

Es zeigen
- Figur 1: ein Prinzipschaltbild der Erfindung und
- Figur 2: einen Ausschnitt der in Figur 1 dargestellten Schaltung im Detail.

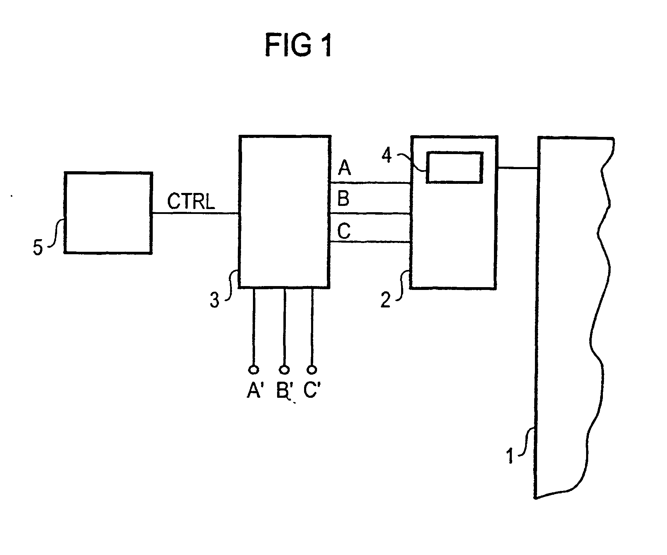

In Figur 1 ist ein erfindungsrelevanter Teil einer integrierten Halbleiterschaltung, beispielsweise eines integrierten Halbleiterspeichers (DRAM), dargestellt. Eine Funktionseinheit 1 kann in einem ersten Betriebszustand oder einem zweiten Betriebszustand betrieben werden. Im Beispiel des DRAM ist die Funktionseinheit 1 das Speicherzellenfeld samt Schaltungsblöcken zu dessen Betrieb wie Speicherzellen, Leseverstärker, Decoder, Spannungsgeneratoren, usw. Beim Hochfahren der Versorgungsspannung befindet sich die Funktionseinheit 1 des DRAM im Standby-Betrieb, d.h. die Spannungsgeneratoren werden im wesentlichen nur zur Ladungserhaltung betrieben, so daß Leckströme ausgeglichen werden. Im Active-Mode sind demgegenüber Wortleitungen und Bitleitungen aktiv geschaltet, wozu interne Spannungsgeneratoren in Vollast betrieben werden und dementsprechend viel Verlustleistung verbraucht wird. Die Umschaltung zwischen Standby- und Active-Mode besorgt eine Steuerungseinrichtung 2. Sie enthält ein Betriebsartenregister 4, dessen Zustand die Betriebsarteinstellung festlegt. Das Betriebsartenregister 4 wird dann entsprechend dem Active-Mode gesetzt, wenn für Signale A, B, C eine vorgegebene Kombination von Signalzuständen vorliegt, zum Beispiel A = L , B = L , C = H . Die Steuersignale A, B, C werden im Normalbetrieb des Halbleiterspeicher aus Steuersignalen A', B', C' abgeleitet. Die Signale A', B', C' werden ihrerseits von einer übergeordneten Steuerungseinrichtung erzeugt, die mit einem externen Mikrocontroller kommuniziert. Dieser stellt für eine Vielzahl von Signalen eine Anzahl von aufeinanderfolgenden unterschiedlichen Signalzuständen bereit. Am Ende der Signalfolge wird schließlich diejenige Signalkombination für das Setzen des Betriebsartenregisters 4 eingespeist.

Es sind Schaltungsmittel 3 vorgesehen, die das Zusammenwirken der Steuersignal A', B', C' sowie eines weiteren extern einzugebenden Steuersignal CTRL steuert. Wenn das weitere Steuersignal CTRL inaktiv, z.B. ein H-Pegel ist, sind die Schaltungsmittel 3 für die Signale A', B', C' transparent. Dies bedeutet, der Signalzustand dieser Signale wird ohne Änderung an die Signale A, B, C weitergegeben. In der Steuerungseinrichtung 2 wird das Betriebsartenregister 4 dementsprechend gesetzt, daß das Speicherzellenfeld 1 vom Standby- in den Active-Mode umschaltet. Wenn das Steuersignal CTRL aktiviert ist, z.B. einen L-Pegel hat, werden die Zustände der Signale A', B', C' nicht weitergeleitet. Statt dessen wird diejenige Zustandskombination der Signale A, B, C die die Umschaltung bewirkt (dies ist die Kombination A = L , B = L , C = H), erzeugt. Die Funktionsweise der Schaltungsmittel 3 ist in nachfolgender Tabelle symbolisch wiedergegeben.

| CTRL | A' | B' | C' | A | B | C |
|---|---|---|---|---|---|---|
| H | ./. | ./. | ./. | A' | B' | C' |
| L | d.c. | d.c. | d.c. | L | L | H |
| (d.c. = don't care) | | | | | | |

Durch Erzeugen eines L-Pegels für das weitere Steuersignal CTRL wird unbeachtlich der bisherigen Einstellung des Betriebsartregisters 4 und des Betriebszustands der Funktionseinrichtung 1 ohne weiteres in den Active-Mode umgeschaltet.

Eine externe Eingabe einer Anzahl von Signalen mit bestimmtem Zeitablauf, ist in diesem Fall nicht mehr erforderlich.

Diese Schaltung eignet sich besonders für den Test der Funktionseinheit 1 im Active-Mode nach dem Anlegen der Versorgungsspannung. Hierzu wird neben der Versorgungsspannung nur an ein Anschlußpad 5, welches das Signal CTRL bereitstellt, eine Probe-Nadel des Testgeräts angelegt. Obwohl bekanntlich bei einem integrierten Halbleiterspeicherchip Anschlußpads nicht randseitig, sondern in der Mitte des Chips angeordnet sind, wird nur relativ wenig Chipfläche verdeckt. Eine Sichtprüfung kann ohne wesentliche Einschränkungen stattfinden. Mittels einer Infrarotanalyse kann ein sogenannter "HOTSPOT" Test im Active-Mode durchgeführt werden. Entsprechendes gilt für Analyseverfahren unter Anwendung von Emissionsmikroskopie.

Das Anschlußpad 5 ist nur für den Schaltungstest von Bedeutung. Es wird insbesondere nicht an ein Anschlußpin des Gehäuses gebondet, wie dies für die übrigen Anschlußpads für Versorgungsspannung und Signalein- und Signalausgabe erforderlich ist. Das Pad 5 kann daher wesentlich kleiner ausgeführt werden als die übrigen, für das Bonden vorgesehen Pads. Das Pad 5 weist beispielsweise Abmessungen von 5 x 5 µm auf. Zum Bonden vorgesehene Pads haben eine Größe im Bereich von 80 x 80 µm bis 100 x 100 µm. Die Seitenlänge des etwa quadratischen Pads liegt daher um mindestens eine Größenordnung niedriger als ein zum Bonden vorgesehenes Pad, d.h. die Seitenlängen verhalten sich wie im Bereich von 1 : 10. Dementsprechend unterscheiden sich die Flächen um zwei Größenordnungen, d.h. das Verhältnis der Flächen liegt zwischen 1 : 10 und 1 : 1000. Da das Pad 5 nach dem Test nicht mehr benutzt wird, wird es zweckmäßigerweise ganz am Ende des Herstellungsprozesses nach dem relevanten Test mit einer Passivierungsschicht überzogen.

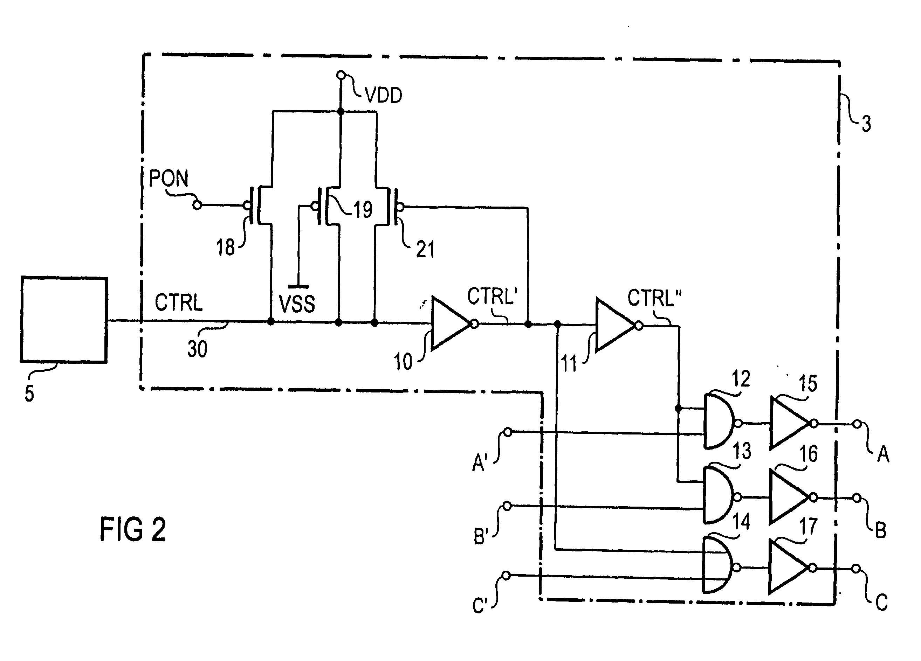

Eine schaltungstechnische Detailrealisierung der Schaltungsmittel 3 ist Figur 2 dargestellt. Einander entsprechende Element sind mit gleichen Bezugszeichen versehen. Die an das Pad 5 angeschlossene Leitung 30, welche das Steuersignal CTRL führt, ist über einen Pull up-Widerstand mit dem Anschluß für das positive Versorgungspotential VDD verbunden. Der Widerstand ist mit einem oder mehreren mit ihren Drain-Source-Strechen in Reihe geschalteten p-Kanal-MOS-Transistoren realisiert, deren Gateanschlüsse an den Anschluß an das negative Versorgungspotential VSS angeschlossen sind. Diese Transistoren bewirken einen hochohmigen Pull up-Widerstand. Der Gesamtwiderstand wird durch die effektive Kanallänge dieser Transistoranordnung festgelegt. Zwischen der Leitung 30 und dem Anschluß für das Versorgungspotential VDD, also parallel zum Pull up-Widerstand, ist ein weiterer p-Kanal-MOS-Transistor 21 geschaltet. Sein Gateanschluß wird vom Steuersignal CTRL gegenphasig angesteuert. Die Leitung 30 ist hierzu mit einem Inverter 10 verbunden, der ausgangsseitig an den Gateanschluß des Transistors 21 angeschlossen ist. Die Beschaltung der Leitung 30 bewirkt, daß dann, wenn am Pad 5 kein Signal eingekoppelt wird, das Potential der Leitung 30 über den Pull up-Widerstand auf das Versorgungspotential VDD angehoben wird. Der Inverter 10 steuert dann den Transistor 21 derart, daß er leitend geschaltet wird und die Klemmung der Leitung 30 an das Potential VDD unterstützt.

Parallel zum Pull up-Widerstand liegt außerdem ein p-Kanal-MOS-Transistor 18, dessen Gateanschluß von einem Signal PON gesteuert wird. Das Signal PON gibt an, daß die Versorgungsspannung hochgefahren ist und ausreichend stabil vorliegt. Unmittelbar nach Anlegen der Versorgungsspannung liegt das Signal PON auf einem L-Pegel, der Transistor 18 ist leitend. Die Leitung 30 wird sicher zum Anschluß für das Potential VDD kurzgeschlossen, auch wenn zu diesem Zeitpunkt der Inverter 10 mangels ausreichender Versorgungsspannung noch nicht ordnungsgemäß schaltet und der Pull up-Widerstand 19 die kapazitive Last der Leitung 30 noch nicht vollständig auf das Potential VDD aufzuladen vermochte. Bei ausreichender Versorgungsspannung schaltet das Signal PON auf einen H-Pegel, so daß der Transistor 18 abgeschaltet wird. Nunmehr sind aber der Pull up-Widerstand und der Inverter 10 sowie der Schalttransistor 21 wirksam.

Das Signal CTRL' am Ausgang des Inverters 10 wird einem NOR-Gatter 14 zugeführt. An dessen anderem Eingang liegt das Signal C' an. Dem NOR-Gatter 14 ist ein Inverter 17 nachgeschaltet, an dem ausgangsseitig das Steuersignal C anliegt, welches in die Steuerungseinrichtung 2 eingespeist wird. Die Elemente 14, 17 führen die logische Funktion eines OR-Schaltglieds aus. Dem Inverter 10 ist ein weiterer Inverter 11 nachgeschaltet, an dem ausgangsseitig das Signal CTRL'' abgegriffen wird. Dieses Signal CTRL" wird je einem NAND-Gatter 12, 13 zugeführt, deren anderer Eingang von dem Signal A' bzw. B' angesteuert wird. Den NAND-Gattern 12, 13 sind Inverter 15, 16 nachgeschaltet, an denen die Signale A, B ausgangsseitig abgegriffen werden. Die Hintereinanderschaltung dieser Gatter wirkt als AND-Schaltglied.

Wenn am Pad 5 das Steuersignal CTRL durch einen L-Pegel aktiviert wird, wird der Transistor 21 abgeschaltet. Zwar fließt durch den hochohmigen Pull up-Widerstand 19 ein geringer Strom. Der L-Pegel des Signals CTRL aber wird von einem externen Treiber, der eine starke Stromsenke ist, bereitgestellt. Die Stromsenkeneigenschaft des aktiven Signals CTRL dominiert somit gegenüber dem Pull-up-Strom des Widerstands 19. Die Schaltung der Elemente 11, ..., 17 bewirkt, das bei aktivem (L-Pegel) Steuersignal CTRL an den Ausgängen der Schaltung 3 die Signale A, B, C in derjenigen Kombination erzeugt werden, die die Steuerungsschaltung 2 veranlaßt, vom Standby- in den Active-Mode umzuschalten (A = L , B = L , C = H). Wenn am Anschlußpad 5 kein Signal aktiv eingespeist wird, führt die Leitung 30 das positive Versorgungspotential VDD. Der Schaltungsteil 11, ..., 17 bewirkt, daß der Zustand der Signale A', B', C' an die Signale A, B, C am Schaltungsausgang unverändert weitergegeben wird. Die Schaltung 3 ist dann für die Signale A', B', C' transparent.

Der zusätzliche Schaltungsaufwand beträgt nur wenige Gatter und Transistoren sowie ein Pad mit äußerst geringen Abmessungen. Die Schaltung kann daher ohne nennenswerten Flächenverbrauch auf dem integrierten Halbleiterchip angeordnet werden. Sie verbessert die Erkennung von Fehlern auf dem Halbleiterchip bei einem Sichttest im Active-Mode. Spezieller Aufwand am Testgerät zur ansosnten notwendigen zeitgerechten Zuführung von einer Vielzahl von Signalen ist nicht mehr erforderlich. Ein solcher Test erfolgt überlicherweise während der Schaltungsherstellung bei ausgewählten Chips auf der Halbleiterscheibe, bevor diese in die einzelnen Chips zertrennt wird.

## Patentansprüche

1. Integrierter Schaltkreis, umfassend:
- eine Funktionseinrichtung (1), die eine erste Betriebsart und eine zweite Betriebsart einnehmen kann, von denen die erste Betriebsart bei Inbetriebnahme voreingestellt ist,
- eine Steuerungseinrichtung (2, 4), durch die die Umschaltung zwischen den zwei Betriebsarten steuerbar ist und der mindestens zwei Steuersignale (A, B, C) zuführbar sind, durch die, wenn eine vorgegebene Kombination von Zuständen der Steuersignale (A, B, C) anliegt, die Steuerungseinrichtung (2) von der ersten in die zweite Betriebsart umschaltbar ist,
- ein Anschlußpad (5), über das ein weiteres Steuersignal (CTRL) einkoppelbar ist,
- mit dem Anschlußpad (5) verbundene Schaltungsmittel (3), durch die die vorgegebene Kombination der Zustände in Antwort auf einen am Anschlußpad (5) eingekoppelten Zustand des weiteren Steuersignals (CTRL) erzeugbar ist und der Steuerungseinrichtung (2, 4) zuführbar ist, wobei
- innerhalb der Schaltungsmittel (3) jedem Steuersignal (A, B, C) zugeordnet ein Anschluß sowie ein logisches Verknüpfungselement (12, 13, 14) vorgesehen sind und jeweils ein Eingang des Verknüpfungselements (12, 13, 14) mit dem Anschluß gekoppelt ist und ein Ausgang des verknüpfungselements das zugeordnete Steuersignal (A, B, C) führt, und
- jeweils das Verknüpfungselement (12, 13, 14) derart ausgeführt ist, daß dann, wenn das weitere Steuersignal (CTRL) den eingekoppelten Zustand aufweist, ein Signal (A', B', C') am zugeordneten Anschluß an den Ausgang des Verknüpfungselements (12, 13, 14) durchgeschaltet wird, und daß dann, wenn das weitere Steuersignal (CTRL) den eingekoppelten Zustand nicht aufweist, ein Signal (CTRL', CTRL'') an einem anderen Eingang des Verknüpfungselements (12, 13, 14) an dessen Ausgang durchgeschaltet wird.

2. Integrierter Schaltkreis nach Anspruch 1,
**dadurch gekennzeichnet, daß**
zwischen das Anschlußpad (5) und einen Anschluß für ein Versorgungspotential (VDD) ein Widerstand (19) geschaltet ist und daß der eingekoppelte Zustand des weiteren Steuersignals (CTRL) gleich einem anderen Versorungspotential (VSS) einer dem Schaltkreis zuführbaren Versorgungsspannung (VDD, VSS) ist.

3. Integrierter Schaltkreis nach Anspruch 2,
**dadurch gekennzeichnet, daß**
parallel zum Widerstand (19) ein Lastpfad eines Schalttransistors (21) geschaltet ist, dessen Steuereingang mit dem Ausgang eines Inverters (10) verbunden ist, und daß der Eingang des Inverters (10) mit dem Anschlußpad (5) verbunden ist.

4. Integrierter Schaltkreis nach Anspruch 2 oder 3,
**dadurch gekennzeichnet, daß**
ein Lastpfad eines weiteres Schalttransistors (18) parallel zum Widerstand (19) geschaltet ist, dessen Steuereingang von einem Signal (PON) steuerbar ist, das angibt, daß die an den Schaltkreis anzulegende Versorgungsspannung (VDD, VSS) stabil angelegt ist.

5. Integrierter Schaltkreis nach einem der Ansprüche 1 bis 4,
**dadurch gekennzeichnet, daß**
das Anschlußpad (5) an zwei bezüglich ihrer Signalpfade in Reihe geschaltete Inverter (10, 11) angeschlossen ist, daß der Ausgang des nachgeschalteten Inverters (11) mit je einem Eingang von zwei UND-Gattern (12, 15; 13, 16) verbunden ist, daß der Ausgang der UND-Gatter (12, 15; 13, 16) je eines der Steuersignale (A, B) führt, daß ein Eingang des nachgeschalteten Inverters (11) mit einem Eingang eines ODER-Gatters (14, 17) verbunden ist und daß ein Ausgang des ODER-Gatters (14, 17) ein weiteres der Steuersignale (C) führt.

6. Integrierter Schaltkreis nach einem der Ansprüche 1 bis 5,
**dadurch gekennzeichnet, daß**
mindestens ein weiteres Anschlußpad vorgesehen ist, um ein Versorgungspotential oder ein Signal ein- oder auszukoppeln, und daß das Anschlußpad (5) eine Fläche aufweist, die um 1:10 bis 1:1000 kleiner ist als die Fläche des weiteren Anschlußpads.

## Claims

1. Integrated circuit, comprising:
- a functional device (1), which can assume a first operating mode and a second operating mode, the first operating mode of which is preset upon start-up,
- a control device (2, 4), by means of which the changeover between the two operating modes can be controlled and to which at least two control signals (A, B, C) can be fed, by means of which, if a predetermined combination of states of the control signals (A, B, C) is present, the control device (2) can be changed over from the first to the second operating mode,
- a connection pad (5), via which a further control signal (CTRL) can be coupled in,
- circuit means (3) connected to the connection pad (5), by means of which circuit means the predetermined combination of the states can be generated in response to a state of the further control signal (CTRL) coupled in at the connection pad (5) and can be fed to the control device (2, 4), in which case
- within the circuit means (3), in a manner assigned to each control signal (A, B, C), a connection and also a logic combination element (12, 13, 14) are provided and in each case an input of the combination element (12, 13, 14) is coupled to the connection and an output of the combination element carries the assigned control signal (A, B, C), and
- the combination element (12, 13, 14) is in each case embodied in such a way that when the further control signal (CTRL) has the coupled-in state, a signal (A', B', C') at the assigned connection is switched through to the output of the combination element (12, 13, 14), and that when the further control signal (CTRL) does not have the coupled-in state, a signal (CTRL', CTRL'') at another input of the combination element (12, 13, 14) is switched through to the output thereof.

2. Integrated circuit according to Claim 1,
**characterized in that**
a resistor (19) is connected between the connection pad (5) and a connection for one supply potential (VDD), and **in that** the coupled-in state of the further control signal (CTRL) is identical to another supply potential (VSS) of a supply voltage (VDD, VSS) that can be fed to the circuit.

3. Integrated circuit according to Claim 2,
**characterized in that**
a load path of a switching transistor (21) is connected in parallel with the resistor (19), the control input of said switching transistor being connected to the output of an inverter (10), and **in that** the input of the inverter (10) is connected to the connection pad (5).

4. Integrated circuit according to Claim 2 or 3,
**characterized in that**
a load path of a further switching transistor (18) is connected in parallel with the resistor (19), the control input of which can be controlled by a signal (PON) specifying that the supply voltage (VDD, VSS) to be applied to the circuit is applied in a stable fashion.

5. Integrated circuit according to one of Claims 1 to 4,
**characterized in that**
the connection pad (5) is connected to two inverters (10, 11) that are connected in series with regard to their signal path, **in that** the output of the inverter (11) connected downstream is connected to a respective input of two AND gates (12, 15; 13, 16), **in that** the output of the AND gates (12, 15; 13, 16) carries a respective one of the control signals (A, B), **in that** an input of the inverter (11) connected downstream is connected to an input of an OR gate (14, 17), and **in that** an output of the OR gate (14, 17) carries a further one of the control signals (C).

6. Integrated circuit according to one of Claims 1 to 5,
**characterized in that**
at least one further connection pad is provided in order to couple a supply potential or a signal in or out, and **in that** the connection pad (5) has an area that is 1:10 to 1:1000 smaller than the area of the further connection pad.

## Revendications

1. Circuit intégré comprenant :
- un dispositif (1) fonctionnel qui peut prendre un premier type de fonctionnement et un deuxième type de fonctionnement parmi lesquels le premier type de fonctionnement est présélectionné lors de la mise en service,
- un dispositif (2, 4) de commande par lequel la commutation entre les types de fonctionnement peut être commandée et auquel peuvent être envoyés au moins deux signaux (A, B, C) de commande par lesquels, lorsqu'une combinaison prescrite d'état des signaux (A, B, C) de commande est présente, le dispositif (2) de commande peut être commuté du premier au deuxième type de fonctionnement,
- une plage (5) de connexion par laquelle un signal (CTRL) supplémentaire de commande peut être injecté,
- des moyens (3) de circuit qui sont reliés à la plage (5) de connexion et par lesquels la combinaison prescrite des états peut être produite en réponse à un état injecté sur la plage (5) de connexion du signal (CTRL) supplémentaire de commande et peut être envoyée au dispositif (2, 4) de commande, dans lequel
- il est prévu dans les moyens (3) de circuit une borne associée à chaque signal (A, B, C) de commande ainsi qu'un élément (12, 13, 14) de combinaison logique, et respectivement une entrée de l'élément (12, 13, 14) de combinaison est couplée à la borne et une sortie de l'élément de combinaison fait passer le signal (A, B, C) de commande associé, et
- respectivement l'élément (12, 13, 14) de combinaison est réalisé de façon à ce que, lorsque le signal (CTRL) supplémentaire de commande présente l'état injecté, un signal (A', B', C') à la borne associée passe à la sortie de l'élément (12, 13, 14) de combinaison et en ce que, lorsque le signal (CTRL) supplémentaire de commande ne présente pas l'état injecté, un signal (CTRL', CTRL") à l'autre entrée de l'élément (12, 13, 14) de combinaison passe à sa sortie.

2. Circuit intégré suivant la revendication 1,
**caractérisé en ce qu'**une résistance (19) est montée entre la plage (5) de connexion et une borne pour un potentiel (VDD) d'alimentation, et **en ce que** l'état injecté du signal (CTRL) supplémentaire de commande est égal à un autre potentiel (VSS) d'alimentation d'une tension (VDD, VSS) d'alimentation pouvant être appliquée au circuit.

3. Circuit intégré suivant la revendication 2,
**caractérisé en ce qu'**en parallèle à la résistance (19)' est monté un trajet de charge d'un transistor (21) de commutation dont l'entrée de commande est reliée à la sortie d'un inverseur (10), et **en ce que** l'entrée de l'inverseur (10) est reliée à la plage (5) de connexion.

4. Circuit intégré suivant la revendication 2 ou 3,
**caractérisé en ce qu'**un trajet de charge d'un autre transistor (18) de commutation est monté en parallèle à la résistance (19) et son entrée de commande peut être commandée par un signal (PON) qui indique que la tension (VDD, VSS) d'alimentation appliquée au circuit est appliquée de façon stable.

5. Circuit intégré suivant l'une des revendications 1 à 4,
**caractérisé en ce que** la plage (5) de connexion est reliée à deux inverseurs (10, 11) montés en série pour ce qui concerne leur trajet de signal, **en ce que** la sortie de l'inverseur (11) en aval est reliée respectivement à une entrée de deux portes (12, 15 ; 13, 16) ET, **en ce que** la sortie des portes (12, 15 ; 13, 16) ET achemine respectivement l'un des signaux (A, B) de commande, **en ce qu'**une entrée de l'inverseur (11) en aval est reliée à une entrée d'une porte (14, 17) OU et **en ce qu'**une sortie de la porte (14, 17) OU achemine un autre des signaux (C) de commande.

6. Circuit intégré suivant l'une des revendications 1 à 5,
**caractérisé en ce qu'**il est prévu une autre plage de connexion pour appliquer ou cesser d'appliquer un potentiel d'alimentation ou un signal, et **en ce que** la plage (5) de connexion a une surface qui est plus petite de 1/10 à 1/1000 que la surface de l'autre plage de connexion.
